# EUROPÄISCHE PATENTANMELDUNG

(11) **EP 2 950 146 A1**
(43) Veröffentlichungstag der Anmeldung: **02.12.2015**
(21) Anmeldenummer: 14170179.7
(22) Anmeldetag: 28.05.2014
(51) Int. Cl.: G03F 7/20, B41F 5/24

(54) **Verfahren und Vorrichtung zur Herstellung einer Flexodruckform**

(71) Anmelder: AKK GmbH, 47809 Krefeld (DE)
(72) Erfinder: Kesper, Peter, 47800 Krefeld (DE)
(74) Vertreter: Cohausz & Florack

(57) **Zusammenfassung**

Die Erfindung betrifft insbesondere ein Verfahren zur Herstellung einer Flexodruckform, bei welchem mindestens eine Flexodruckplatte abschnittsweise auf einem Flexodruckträger befestigt wird. Ein derartiges bekanntes Verfahren wird dadurch vorteilhaft weitergebildet, dass die Flexodruckplatte zumindest teilweise unbelichtet auf dem Flexodruckträger befestigt wird, dass die freibleibenden Abschnitte auf dem Flexodruckträger mit mindestens einer Ausgleichsschicht abgedeckt werden, dass auf die Flexodruckplatte und die Ausgleichsschicht eine Maske aufgelegt wird und dass die maskierte Flexodruckplatte belichtet wird.

## Beschreibung

Die Erfindung betrifft ein Verfahren zur Herstellung einer Flexodruckform, bei welchem mindestens eine Flexodruckplatte abschnittsweise auf einem Flexodruckträger befestigt wird. Darüber hinaus betrifft die Erfindung eine Vorrichtung zur Herstellung einer Flexodruckform mit einer Auflage für einen Flexodruckträger und einem Register.

Aus dem Stand der Technik sind Verfahren zur Herstellung einer Flexodruckform bekannt, bei welchen inbesondere bei großen Flexodruckformen, etwa zum Bedrucken von Wellpappe, eine Flexodruckplatte nur abschnittsweise auf den Flexodruckträger, etwa einer Polyesterfolie, zum Beispiel durch Kleben befestigt werden. Dieses abschnittsweise Aufkleben von Flexodruckplatten auf einen Flexodruckträger ist darin begründet, dass das Grundmaterial zur Herstellung einer Flexodruckplatte, heute häufig als Fotopolymer ausgebildet, erhebliche Kosten verursacht. Bei großen Flexodruckformen, wie sie beispielsweise beim Bedrucken von Wellpappe eingesetzt werden, in denen darüber hinaus große Bereiche unbedruckt bleiben, wäre das vollflächige Aufbringen der Flexodruckplatte auf den Flexodruckträger zu kostenintensiv. Bei derartigen Fotopolymerplatten handelt es sich beispielsweise um Fotopolymerschichten, die zur Stabilisierung und besseren Handhabung bereits bis zu einer bestimmten Tiefe entwickelt worden sind.

Für derartige Anwendungen ist es Stand der Technik, dass die Flexodruckplatte zunächst fertig entwickelt wird und anschließend auf den Flexodruckträger aufgeklebt wird. Hierbei ist problematisch, dass ein präzises Aufkleben der fertigen Flexodruckplatten einen hohen Aufwand mit sich bringt und den Einsatz ausgebildeter Fachkräfte erfordert. Zwar existieren Hilfsmittel zur Ausrichtung der zu befestigenden Flexodruckträger relativ zum Register, jedoch sind diese auf der einen Seite apparativ aufwändig und weiterhin in ihrer Bedienung anspruchsvoll. Ausgehend von diesem Stand der Technik liegt der vorliegenden Erfindung die Aufgabe zu Grunde, die bekannten Verfahren zur Herstellung einer Flexodruckform sowie die zugehörigen Vorrichtungen zur Herstellung einer Flexodruckform dahingehend auszugestalten und weiterzubilden, dass mit geringem apparativen und händischem Aufwand eine sehr präzise Anordnung der Flexodruckplattenabschnitte auf dem Flexodruckträger gewährleistet ist.

Gemäß der ersten Lehre der Erfindung sind die bekannten Verfahren zur Herstellung einer Flexodruckform derart ausgestaltet, dass die Flexodruckplatte zumindest teilweise unbelichtet auf dem Flexodruckträger befestigt wird, dass die freibleibenden Abschnitte auf dem Flexodruckträger mit mindestens einer Ausgleichsschicht abgedeckt werden, dass auf die Flexodruckplatte und die Ausgleichsschicht eine Maske aufgelegt wird und dass die maskierte Flexodruckplatte belichtet wird.

Die erfindungsgemäße Ausgestaltung des Verfahrens gewährleistet eine reproduzierbare und außerordentlich präzise Ausrichtung der Flexodruckplatte gegenüber dem Flexodruckträger.

Dies wird einerseits dadurch gewährleistet, dass die Belichtung der Flexodruckplatte erst nach dem Befestigen dieser auf den Flexodruckträger erfolgt, wobei die Maske zur Belichtung mit einfachen Mitteln sehr präzise gegenüber dem Flexodruckträger ausgerichtet werden kann. Darüber hinaus wird durch die Ausgleichsschicht gewährleistet, dass die Maske vollkommen plan über die gesamte Fläche des Flexodrucktgrägers aufliegt und so keine Verzerrungen oder Verschiebungen durch durchhängen oder durchbiegen entstehen. Die so maskierten Flexodruckplatten werden nun in an sich üblicher Weise fertig belichtet und entwickelt.

Eine erste vorteilhafte Ausgestaltung erfährt das erfindungsgemäße Verfahren dadurch, dass die Flexodruckplatte, die Ausgleichsschicht und die Maske mit Hilfe eines Vakuums in Belichtungsrichtung aufeinander gepresst werden. Durch dieses Aufeinanderpressen der abbildungsrelevanten Schichten wird ein planes Aufliegen der Maske auf den Abschnitten der Flexodruckplatte gewährleistet. Dies führt zu einer weiter verbesserten Abbildungspräzision.

Schließlich erfährt das erfindungsgemäße Verfahren eine weitere Ausgestaltung dadurch, dass die Maske mit Hilfe eines Registers relativ zur Flexodruckform positioniert wird. Durch Nutzung des am Flexodruckträgers zum Zwecke seiner Positionierung auf der Flexodruckwalze regelmäßig vorgesehenen Registers wird auf einfachste Art und Weise eine sehr präzise Ausrichtung der Maske gewährleistet.

Gemäß der zweiten Lehre der Erfindung wird eine bekannte Vorrichtung zur Herstellung einer Flexodruckform dadurch ausgestaltet und weitergebildet, dass die Vorrichtung eine Belichtungseinheit zur Belichtung mindestens einer zumindest abschnittsweise auf dem Flexodruckträger befestigten und zumindest teilweise unbelichteten Flexodruckplatte aufweist.

Die bekannten Vorrichtungen zur Herstellung einer Flexodruckform weisen keine derartige Belichtungseinheit auf, da bei diesen die Flexodruckplatten abschnittsweise und fertig entwickelt auf dem Flexodruckträger befestigt werden. Erfindungsgemäß erfolgt die Belichtung jedoch erst bei bereits auf dem Flexodruckträger befestigten Flexodruckplatten. Hierdurch wird die bereits oben in Bezug auf das erfindungsgemäße Verfahren erläuterte präzise Ausrichtung gewährleistet.

Eine besonders bevorzugte Ausgestaltung erfährt die erfindungsgemäße Vorrichtung dadurch, dass die Vorrichtung eine lichtdurchlässige Abdeckung für den Flexodruckträger, mindestens eine auf dem Flexodruckträger befestigte Flexodruckplatte, mindestens eine auf dem Flexodruckträger aufliegende Ausgleichsschicht und eine auf der Flexodruckplatte und der Ausgleichsschicht aufliegenden Maske aufweist und dass eine Vakuumpumpe zur Erzeugung eines Vakuums zwischen der Auflage und der Abdeckung vorgesehen ist. Durch diese Ausgestaltung der erfindungsgemäßen Vorrichtung wird es gewährleistet, dass die Maske auf den Flexodruckplatten und der Ausgleichsschicht plan fixiert wird, so dass die gewünschte hohe Abbildungsgenauigkeit gewährleistet ist.

Es gibt nun eine Vielzahl von Möglichkeiten, die erfindungsgemäßen Lehren auszugestalten und weiterzubilden. Nur beispielsweise wird hierzu verwiesen auf die nachfolgende Beschreibung eines Ausführungsbeispiels in Verbindung mit der Zeichnung. In der Zeichnung zeigt
- Fig.1: ein Ausführungsbeispiel einer erfindungsgemäßen Vorrichtung zur Herstellung einer Flexodruckform in einer Aufsicht und
- Fig. 2: das Ausführungsbeispiel einer erfindungsgemäßen Vorrichtung zur Herstellung einer Flexodruckform in einem seitlichen Schnitt.

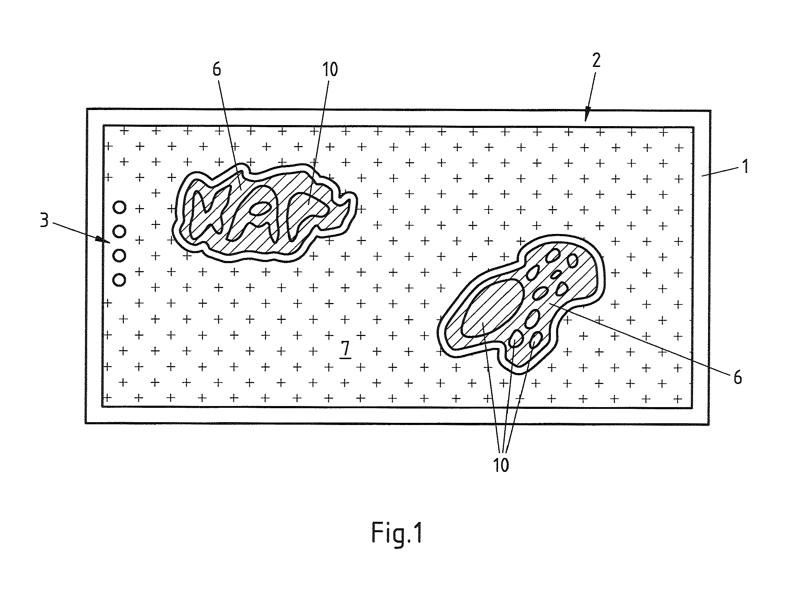

Die in Fig. 1 dargestellte erfindungsgemäße Vorrichtung zur Herstellung einer Flexodruckform weist eine Auflage 1 auf, auf der ein Flexodruckträger 2 aufliegt. Darüber hinaus weist die Vorrichtung ein Register 3 zur Ausrichtung zunächst des Flexodruckträgers 2 relativ zur Auflage 1 auf.

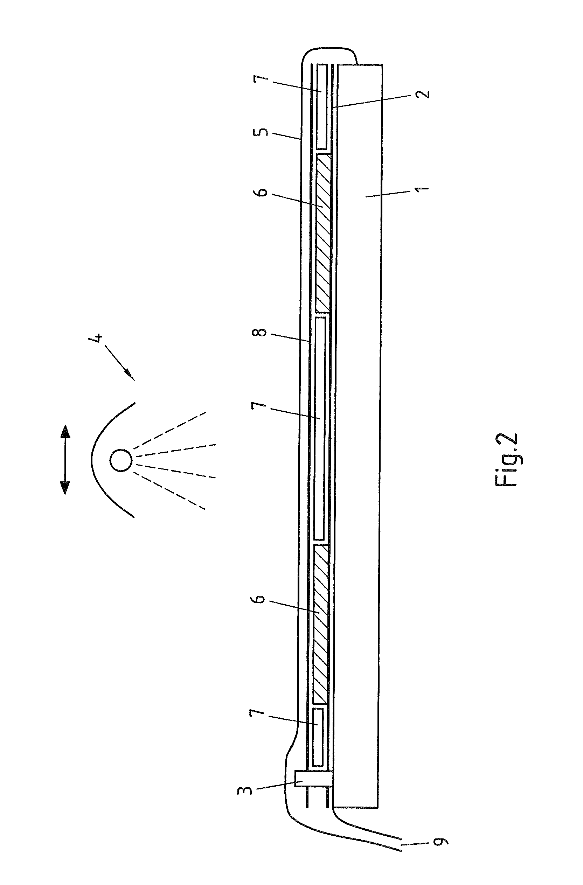

Aus Fig. 2 wird ersichtlich, dass erfindungsgemäß oberhalb der Auflage 1 eine Belichtungseinheit 4 vorgesehen ist, die im dargestellten Ausführungsbeispiel als linienförmige Lichtquelle skizziert ist, die zur vollständigen Belichtung relativ zur Auflage 1 verfahren werden kann.

In Fig. 2 ist weiter eine lichtdurchlässige Abdeckung 5 dargestellt, welche den Flexodruckträger 2, die auf dem Flexodruckträger 2 befestigten Flexodruckplatten 6, die ebenfalls auf dem Flexodruckträger 2 aufliegende Ausgleichsschicht 7 und eine wiederum auf der Flexodruckplatte 6 und der Ausgleichsschicht 7 aufliegenden Maske 8 abdeckt.

Über einen Unterdruckanschluss 9 wird der Zwischenraum zwischen der Abdeckung 5 und der Auflage 1 zumindest teilweise evakuiert, so dass die Maske 8 auf die Flexodruckplatten 6 und die Ausgleichsschicht 7 aufgepresst wird, wobei durch die Anordnung der Ausgleichsschicht 7 gewährleistet ist, dass die Maske 8 in den von der Ausgleichsschicht 7 abgedeckten Bereichen nicht durchhängt oder Wellen wirft.

Wie aus dem Stand der Technik an sich bekannt, werden die zumindest teilweise unbelichteten Flexodruckplatten 6 vorzugsweise mit Hilfe eines Schneidplotters geschnitten. Zweckmäßigerweise erfolgt auch der Zuschnitt der Ausgleichsschicht 7 mit Hilfe eines solchen an sich bekannten Schneidplotters. Als Ausgleichsschicht 7 können verschiedene kostengünstige Materialien verwendet werden. Vorzugsweise haben diese eine im Wesentlichen übereinstimmende Dicke mit den Flexodruckplatten 6. In Frage kommen beispielsweise Materialien wie Pappe oder elastische Materialien wie etwa Gummi- oder Polymerplatten.

Dadurch, dass die Maske 5 in gleicher Weise wie der Flexodruckträger 2 mit Hilfe eines Registers 3 ausgerichtet wird, ist die gewünscht exakte Ausrichtung in besonders einfacher Art und Weise gewährleistet.

Die mit Hilfe der Maske 5 innerhalb der Flexodruckplatten 6 zu belichtenden Bereiche 10 sind in Fig. 1 skizziert.

## Patentansprüche

1. Verfahren zur Herstellung einer Flexodruckform, bei welchem mindestens eine Flexodruckplatte abschnittsweise auf einem Flexodruckträger befestigt wird, **dadurch gekennzeichnet, dass** die Flexodruckplatte zumindest teilweise unbelichtet auf dem Flexodruckträger befestigt wird, dass die freibleibenden Abschnitte auf dem Flexodruckträger mit mindestens einer Ausgleichsschicht abgedeckt werden, dass auf die Flexodruckplatte und die Ausgleichsschicht eine Maske aufgelegt wird und dass die maskierte Flexodruckplatte belichtet wird.

2. Verfahren nach Anspruch 1, **dadurch gekennzeichnet, dass** die Flexodruckplatte, die Ausgleichsschicht und die Maske mit Hilfe eines Vakuums in Belichtungsrichtung aufeinander gepresst werden.

3. Verfahren nach einem der Ansprüche 1 oder 2, **dadurch gekennzeichnet, dass** die Maske mit Hilfe eines Registers relativ zur Flexodruckform positioniert wird.

4. Vorrichtung zur Herstellung einer Flexodruckform mit einer Auflage (1) für einen Flexodruckträger (2) und einem Register (3), **dadurch gekennzeichnet, dass** die Vorrichtung einer Belichtungseinheit (4) zur Belichtung mindestens einer zumindest abschnittsweise auf dem Flexodruckträger (2) befestigten und zumindest teilweise unbelichteten Flexodruckplatte (6) aufweist.

5. Vorrichtung nach Anspruch 4, **dadurch gekennzeichnet, dass** die Vorrichtung eine lichtdurchlässige Abdeckung (5) für den Flexodruckträger (2), mindestens eine auf dem Flexodruckträger (2) befestigte Flexodruckplatte (6), mindestens eine auf dem Flexodruckträger (2) aufliegende Ausgleichsschicht (7) und eine auf der Flexodruckplatte (6) und der Ausgleichsschicht (7) aufliegende Maske (8) aufweist und dass eine Vakuumpumpe zur Erzeugung eines Vakuums zwischen der Auflage (1) und der Abdeckung (5) vorgesehen ist.
